# EUROPEAN PATENT SPECIFICATION

(11) **EP 0 667 538 B1**
(45) Date of publication and mention of the grant of the patent: **14.06.2000**
(21) Application number: 95400057.6
(22) Date of filing: 12.01.1995
(51) Int. Cl.: G01S 13/90, G01R 23/163

(54) **Non-contact type wave signal observation apparatus**
Berührungslose-Beobachtungsvorrichtung von Wellensignalen
Appareil d'observation d'un signal sans contact

(30) Priority: 12.01.1994 JP 157494; 12.01.1994 JP 157594; 13.01.1994 JP 190494; 19.01.1994 JP 410794; 21.01.1994 JP 540294
(43) Date of publication of application: 16.08.1995
(60) Divisional application: 99203844.8
(73) Proprietor: ADVANTEST CORPORATION, Nerima-Ku Tokyo (JP)
(72) Inventor: Kitayoshi, Hitoshi, c/o Advantest Corporation, Tokyo (JP)
(74) Representative: Joly, Jean-Jacques

(56) References cited:
- EP-A- 0 140 539
- EP-A- 0 324 880
- EP-A- 0 408 112
- EP-A- 0 555 099
- DE-A- 4 133 619
- FR-A- 2 096 730
- US-A- 3 685 051
- US-A- 4 309 602
- US-A- 4 561 019
- US-A- 4 713 782
- US-A- 4 800 387
- US-A- 5 175 698
- PATENT ABSTRACTS OF JAPAN vol. 7 no. 138 (P-204) ,16 June 1983 & JP-A-58 053778 (TOKYO KEIKI KK) 30 March 1983,

## Description

### FIELD OF THE INVENTION

The invention relates to non-contact type wave signal observation apparatus. More particularly, the invention relates to an apparatus which measures, in a non-contact manner, transfer functions of distributed constant networks mainly used in the microwave and millimeter wave region and which do not contain internal signal sources. The term "distributed constant networks" is intended to mean high frequency networks such as those operative at microwave frequencies and above. The networks typically include passive elements, active elements and transmission lines having distributed properties, such as microstrip lines, slot lines and coaxial cables.

### BACKGROUND OF THE INVENTION

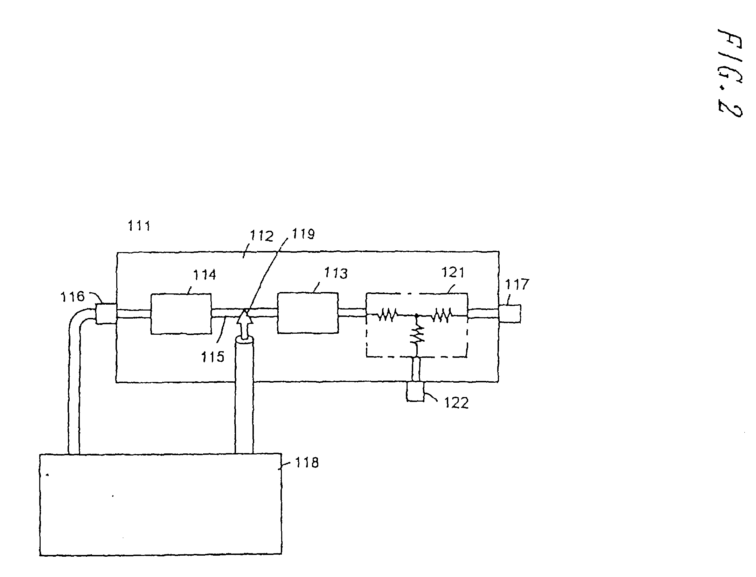

Fig.2 illustrates a prior art transfer function measurement apparatus, this apparatus being a contact-type measurement apparatus. A distributed constant network 111 under observation is composed of a substrate 112 bearing a passive element 113 and an active element 114 connected by a distributed constant line 115 such as a microstrip line. Input terminal 116 and output terminal 117, which respectively input and output signals, are provided in the network 111.

In the prior art transfer function measurement apparatus, the transfer function between the input terminal 116 and the output terminal 117 is measured, as follows. A test signal is input from the network analyzer 118 to the input terminal 116. The corresponding signal output from the output terminal 117 is input to the network analyzer and the transfer function is calculated.

In the prior art transfer function measurement apparatus, the transfer function at a location between the input and output terminals is measured as follows. A test signal is input from the network analyzer 118 to the input terminal 116. A contact type probe 119 is placed in contact with the location between the input and output terminals of the network 111 where it is desired to measure the transfer function, and a signal is taken out at that location. The extracted signal is input to the network analyzer 118 and the transfer function is calculated.

When it is known beforehand that it will be necessary to measure the transfer function at a particular location between the input and output terminals of the network 111, a power splitter 121 is connected at that particular location. The network 111 is provided beforehand with a test terminal 122 connected to the power splitter 121 and signals are input and output through test terminal 122. A test signal is passed between the input terminal 116 and the test terminal 122 and/or between the test terminal 122 and the output terminal 117 and the corresponding output signal is extracted for calculation of the transfer function.

The contact type probe 119 influences the circuit parameters which it is measuring. Thus, it is impossible to obtain an accurate measurement when a contact-type probe is used to access a location between the input and output terminals of the network 111. Moreover, when test terminal 122 is used there is a comparatively large loss of signal level because of the presence of power splitter 121 in the network. Furthermore, power splitter 121 may be integrated into a unit with other circuit elements of the network 111. In such a case it becomes difficult to manufacture a network which performs a desired operation correctly.

### SUMMARY OF THE INVENTION

The present invention provides a non-contact type transfer function measurement apparatus in which the transfer function of a distributed constant network is measured, as follows. The transfer function measurement means of the invention supplies an input signal to the distributed constant network under observation. An observation plane is set up spaced apart from the network under observation and an electromagnetic wave is received at observation points on the observation plane. First, the transfer function between the input of the network under observation and each of the observation points is calculated. These calculated transfer functions are processed by hologram reconstruction calculations using the inverse-Fresnel transform or the Fourier transform of received signals at each observation frequency so as to derive transfer functions between the input terminal and each point in the distributed constant network under observation. The results for any specified point in the distributed constant network under observation may be displayed.

Weak electromagnetic waves are radiated from distributed constant networks operating at frequencies in the microwave and millimeter wave region. In apparatus according to the invention, these weak electromagnetic waves are received and measured. Signals in the network can be reconstructed by using hologram reconstruction calculations on signals received in the observation plane. In. preferred embodiments of the invention, the shape of the distributed constant network under observation is displayed on a display and results of the above-mentioned hologram reconstruction calculations for one frequency are displayed. When an arbitrary position on the two-dimensional display is specified then the frequency characteristic of the network location corresponding to that portion of the display is displayed. In this case it is desirable that the shape display and the two-dimensional display of results are displayed in an overlay fashion.

It is also preferred that the results of the hologram reconstruction calculations should be corrected to compensate for phase and gain changes attributable to the frequency responses of the transfer function measurement system and the observation system.

Time domain responses can be displayed by performing the inverse-Fourier transform on the displayed hologram reconstruction results.

### BRIEF DESCRIPTION OF'THE DRAWINGS

Fig. 1 is a block diagram showing an embodiment of a non-contact type transfer function measurement apparatus according to the invention.

Fig.2 is a block diagram showing a prior art transfer function measurement apparatus.

Fig.3 is a block diagram showing an embodiment of a complex wave interference information display apparatus which may be used to display data obtained by the non-contact type transfer function measurement apparatus according to the invention.

Fig.4 shows an example of results displayed using the apparatus of Fig.3.

### DESCRIPTION OF THE PREFERRED EMBODIMENT

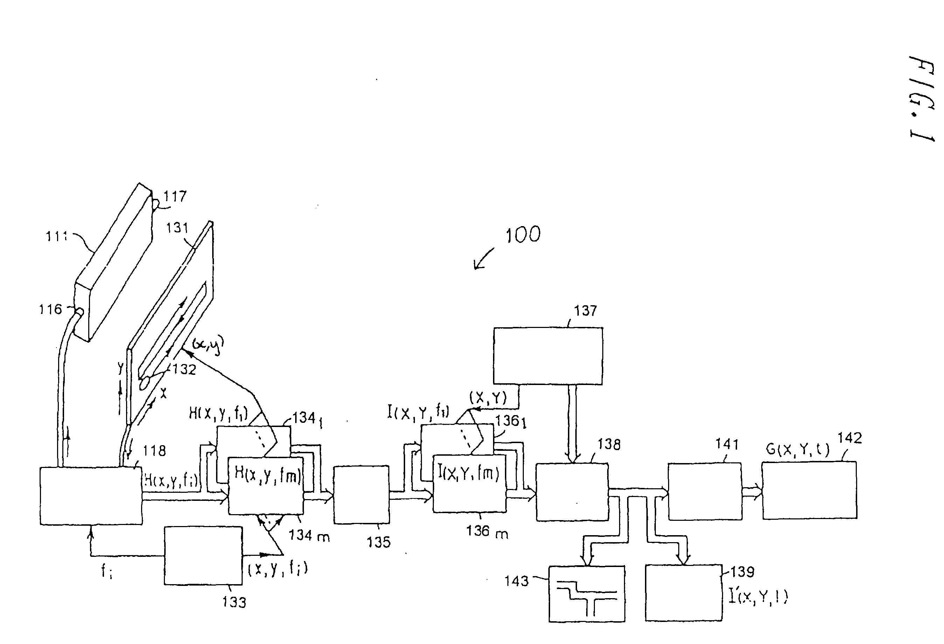

A preferred embodiment of non-contact type transfer function measurement apparatus according to the invention is explained below referring to Fig.1.

An observation plane 131 is set up in the vicinity of a distributed constant network 111 which is to be observed. The distributed constant network 111 has an input terminal 116 and an output terminal 117. A signal is input to the input terminal 116 of the distributed constant network 111 and then transfer function measuring means 100 measures the transfer function H(x,y,fᵢ) between the input terminal 116 of the distributed constant network 111 and each observation point (x,y) on the observation plane 131 at an observation frequency fᵢ. The input signal may be provided by a network analyzer 118 of the transfer function measuring means 100.

Scanning-antenna receiving means is installed in the receiving plane 131. For instance, an antenna 132 may be provided in the observation plane 131 so as to receive electromagnetic waves radiated from the distributed constant network 111. In this case, the antenna 132 is successively moved from one observation point (x,y) to the next so as to successively output to the network analyzer 118 voltages indicative of the electromagnetic waves received at each respective observation point on the observation plane. Alternatively, an array of individual antennas can be used, antennas of the array being positioned to correspond to the observation points (x,y) of the observation plane, and each element of the array can successively output its received signal to the network analyzer 118. One example of a scanning-antenna receiving means suitable for use in the present embodiment is disclosed in "Near-Field Antenna Measurements" by Dan Slater (Artech House, 1991).

The network analyzer 118 has data available to it regarding the signal input to the input terminal 116 of the distributed constant network 111 and regarding the electromagnetic waves received at each observation point (x,y) on the observation plane and, thus, can determine transfer functions between the input terminal 116 and each observation point (x,y). A measurement control unit 133 controls the measurement position (x,y) on the observation plane and the measurement frequency fᵢ so as to ensure that data is obtained in respect of a plurality of observation points (x,y) at a plurality of observation frequencies f₁ to fₘ (i.e. i = 1 to m). Measurement control unit 133 controls the storing of the sets of measured transfer functions H(x,y,f₁) to H(x,y,fₘ) in data memories 134₁ to 134ₘ.

The set of transfer function data H(x,y,fᵢ) for each observation frequency fᵢ is taken out of the respective data memory 134ᵢ and is subjected to hologram reconstruction calculations in a hologram reconstruction calculation unit 135. As a result, the two-dimensional radiation pattern on the network 111 is reconstructed from the two-dimensional radiation pattern received on the observation plane 131. That is, transfer function data relating to points (X,Y) in the distributed constant network 111 are extracted from the signals (resulting from interference between electromagnetic waves produced by different portions of the distributed constant network and propagating in space) measured in the observation plane

Let L be the distance between the observation plane 131 and the distributed constant network under observation, D be the dimension of the observation plane 131 and λᵢ be the observation wavelength. When L < D²/λᵢ, transfer functions I(X,Y,fᵢ) for points (X,Y) in the distributed constant network 131 are obtained by performing an inverse-Fresnel transform to the transfer functions H(x,y,fᵢ), as in the following equation:${\text{I(X,Y,f}}_{\text{i}} {\text{) = K ∫∫H(ξ,η,f}}_{\text{i}} {\text{)exp{jπ/λ}}_{\text{i}} {\text{L((ξ-x)}}^{\text{2}} {\text{+ (η-y)}}^{\text{2}} \text{} dξ dη}$ where K = -jλᵢL exp (j2πL/λᵢ), λᵢ = c/fᵢ, c is the speed of light, ξ is a variable range of x and η is a variable range of y.
Actually, the Fourier transform (here shown by F) and the inverse-Fourier transform (here shown by F⁻¹) are used according to the following equations:${\text{I(X,Y,f}}_{\text{i}} {\text{) = F}}^{\text{-1}} {\text{[F [H(x,y,f}}_{\text{i}} {\text{)] F[P(x,y,f}}_{\text{i}} \text{)]]}$ where${\text{P(x,y,f}}_{\text{i}} {\text{) = exp(-jπ (x}}^{\text{2}} {\text{+y}}^{\text{2}} {\text{)/λ}}_{\text{i}} \text{L).}$

When L>D²/λᵢ, transfer functions I(u,v,fᵢ) are obtained for the points in the distributed constant network 131, (u being an elevation angle and v being an azimuth angle defining the position of the points in the distributed constant network as seen from the observation plane), by performing a Fourier transform on the transfer functions H(x,y,fᵢ) according to the following equation:${\text{I(u,v,f}}_{\text{i}} {\text{) = ∫∫H(x,y,f}}_{\text{i}} \text{) exp{-j2π(ux+vy)} dx dy}$

The results of the hologram reconstruction calculations performed by the hologram reconstruction calculation unit 135, for example the results I(X,Y,f₁) to I(X,Y,fₘ) produced by an inverse-Fresnel transform, are stored in image memories 136₁ to 136ₘ. A display control unit 137 can specify a point (Xₙ,Yₙ) in the distributed constant network 111 as a point in respect of which data is to be displayed. Corresponding reconstructed output data I(Xₙ,Yₙ,f₁) to I(Xₙ,Yₙ,fₘ) is read out from memories 136₁ to 136ₘ and supplied to a frequency characteristic corrector 138. The frequency characteristic corrector 138 is also supplied, by the display control, unit 137, with frequency characteristic compensation data corresponding to the expected frequency characteristic of an electromagnetic wave leaking from point (Xₙ,Yₙ) of the distributed constant network 111 (taking into account known parameters, for. example, the width and thickness of the microstrip line, etc.). The frequency characteristic corrector 138 determines the value of a correction factor needed to compensate for the frequency characteristic indicated by the display control unit 137 and to compensate for frequency characteristics of the observation system (e.g. scanning-antenna receiving means) and multiplies the transfer function data by this correction factor. The corrected data I'(Xₙ,Yₙ,f₁) to I'(Xₙ,Yₙ,fₘ) is displayed on a display unit 139.

Furthermore, in this embodiment an inverse-Fourier transform is performed on the output of the frequency characteristic corrector 138 by an inverse Fourier transform unit 141. The transformed data G(X,Y,t) is displayed on a further display unit 142 as a signal waveform. The physical shape of the distributed constant network 111 is displayed on a still further display 143. Display control unit 137 can specify a desired point (Xₙ,Yₙ) in the distributed constant network 111 to be indicated on the image displayed by display unit 143, for example by commanding the display of a cursor at the appropriate location on the display unit 143. Any data I(X,Y,fᵢ) in the data memories 136₁ to 136ₘ, or data I'(X,Y,fᵢ) output by the frequency characteristic corrector 138, may be displayed on the display unit 143 either in parallel with, or overlaid on, the representation of the distributed constant network 111.

The video data for generating the displayed image of the physical shape of the distributed constant network 111 may be based on numerical data representing the shape of the network written on a sheet, on computer generated data, etc. In the latter case, the data may be generated by a CAD system which is used for design of the network 111 and may be stored in a memory associated with the display unit 143. Furthermore, the shape of the network 111 may be represented on a transparent sheet or film and laid over a display on which the above-mentioned data I(X,Y,fᵢ), I'(X,Y,fᵢ) is to be displayed.

If it is desired to know the transfer function only at one location, or a small selection of locations, on the network 111, then it is not necessary to perform hologram reconstruction calculations for all points in the network 111, that is, hologram reconstruction calculations can be performed only for that or those desired location(s) (X,Y) or (u,v). If the frequency characteristic of the observation system and the radiation frequency characteristic of the network 111 are comparatively smooth within the range of the observation frequency then frequency characteristic corrector 138 can be omitted. Moreover, the display units 139, 142, 143 may be unified into a single display unit displaying data in parallel or switched fashion.

Apparatus according to the present invention provides advantages as explained hereafter. First of all, the transfer function is calculated between the input terminal of the network under observation and each observation point (x,y) on an observation plane and then hologram reconstruction calculations are performed to convert these measurement results to reconstructed output values for points in the network 111. Therefore, an accurate value for the transfer function between the input terminal and any chosen point of the network under observation can be found, in a non-contact manner. Moreover, this apparatus avoids the problems of signal loss associated with use of a signal splitter and test terminal, and avoids the problem of complication of network design associated with incorporation of a signal splitter into an integrated unit with other elements of the network.

In the preferred embodiment of the invention, the results of the hologram reconstruction calculations are displayed in two-dimensions together with the shape of the network. Such a display readily enables an abnormal location to be seen, such as a location where, because of soldering, abnormal radiation is being generated. Furthermore, this display makes it is simple to specify, by referring to the displayed shape, a location in the network for which data is desired to be known (e.g. using a touch-screen display, or by using manual control of a cursor position, etc.).

In the preferred embodiment of the invention, transfer functions can be accurately measured, without being distorted by the frequency characteristics of the network 111 or the observation system, by virtue of the use of the frequency characteristic corrector 138.

When the network 111 is incorporated into comparatively large equipment, transfer functions can similarly be measured by non-contact by using the Fourier transform for hologram reconstruction calculations.

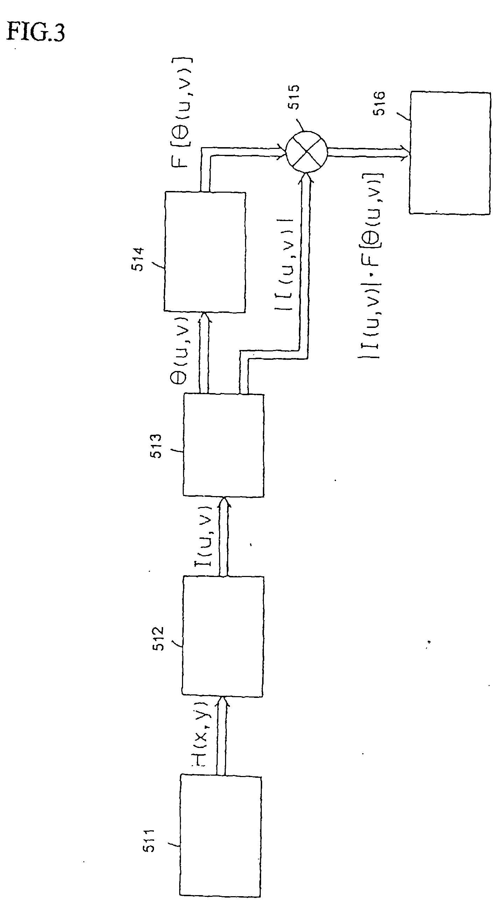

Fig.3 shows a preferred embodiment of display apparatus for complex wave information which may be used to display the data obtained by the non-contact type signal observation apparatus according to the present invention. Two-dimensional interference data H(x,y) regarding electromagnetic waves in three-dimensional space is obtained from interference data observation means 511. In this example, positions (x,y) in the observation plane are designated using an orthogonal co-ordinate system. A hologram reconstruction unit 512 performs hologram reconstruction calculations using the two-dimensional interference data H(x,y). The Fraunhofer transform is used in the hologram reconstruction calculations, according to the; following equation:$\text{I(u,v) = ∫∫H(x,y) exp{-2jπ (ux+vy)} dx dy}$ where u and v are the azimuth angle and the elevation angle, respectively, when viewed from point (x,y) on the observation plane. For instance, at observation points (x,y) on the observation plane spaced apart from the electromagnetic wave source by a distance Z, two-dimensional interference data H(x,y) are observed which represent the data from the source subjected to the transfer function of exp{(jπ/λZ)(x²+y²)}. If hologram reconstruction calculations are performed on this two-dimensional interference data H(x,y) the above propagation function becomes jλZ exp{-jπλZ(u²+v²)}. In addition, the Fourier integral of the observation plane is convolved into this.

A co-ordinate converter 513 converts the result of such hologram reconstruction calculations from orthogonal co-ordinates to polar co-ordinates I(u,v). That is, the real part and the imaginary part of I(u,v) is calculated. The amplitude and the phase of I(u,v) which corresponds to these real part and imaginary parts are also calculated. A hue converter 514 converts the phase information θ(u,v) of the co-ordinate-converted data into a colour signal F[θ(u,v)] of a corresponding hue. A multiplication unit 515 modulates the colour signal F[θ(u,v)] by multiplying it by the amplitude information |I(u,v)| of the coordinate-converted data from co-ordinate converter 513. The modulated output |I(u,v)| • F[θ(u,v)] is displayed on a colour display unit 516 as a colour image in the plane of u and v.

For an electromagnetic wave source which is close to the observation plane, the observed amplitude information |I(u,v)| of I(u,v) is large and drops off rapidly towards the periphery of the image corresponding to the source and the observed phase information θ(u,v) changes comparatively slowly while going from the center to the surrounding of the image corresponding to the source. On the other hand, for an electromagnetic wave source which is further away from the observation plane, the observed amplitude information of I(u,v) is small and weakens comparatively slowly while going from the center to the periphery of the image corresponding to the source and the observed phase information changes comparatively rapidly while going from the center to the surrounding of the image corresponding to the source.

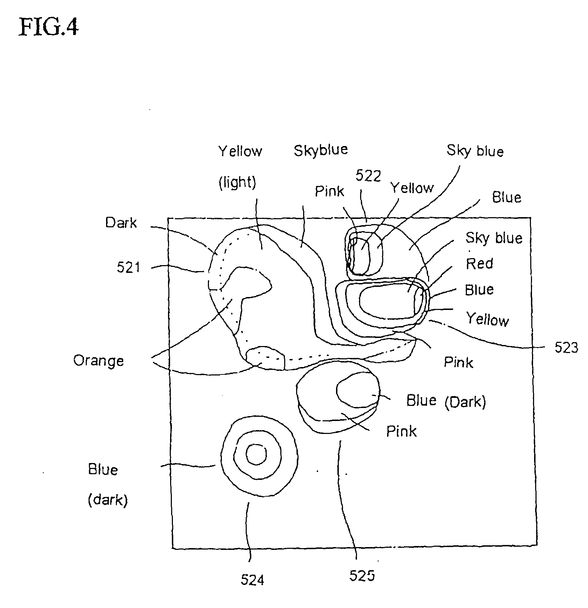

Fig.4 is an example of an image displayed on the display unit 516 when waste/leakage radiation from a piece of electronic equipment is observed at the observation plane by the apparatus of the invention, complex two-dimensional electromagnetic wave interference data is obtained and processing is performed as in the case of Fig.3. The large image 521 on the left upper part of the display is bright, with the brightness reducing rapidly towards the periphery of the image, and the stripes of colour in the image are wide meaning that the observed phase information changes comparatively slowly while going from the center to the surrounding of the image. Therefore, it is understood that image 521 is near the observation plane. Moreover, the colour stripes look wider on the left-hand side than on the right-hand side of image 521 and so an electromagnetic wave of this waste radiation is judged to radiate from the left as seen in the figures.

Image 522, to the right and slightly above image 521 on the image display, is smaller than image 521, has weak brightness and the colour striping is detailed. That is, the phase changes rapidly from the center of the image towards the edges and the striping at the right of the image is coarser than that at the left. That is, it is deduced that image 522 corresponds to a radiation source which is further away and to the right of that corresponding to image 521.

Image 523, between the lower right-hand portion of image 521 and image 522, is slightly larger and brighter than image 522 and the thickness of the colour stripe is about the same as for image 522. Therefore, the radiation source of image 521 is judged to be located at about the same distance as image 522 from the observation plane. However, image 523 corresponds to a slightly stronger source and, from the colour striping, it is understood that this source is radiating to the left because the colour stripes on the right-hand side are finer than those on the left-hand side.

Image 524 spaced apart from image 521 has light and dark portions, the maxilla of the colour stripes are only just fatter than that of the image 522. Therefore, it is judged to correspond to a weak radiation source at a distance which is the same or more than that of the images 522, 523 from the observation plane in the direction perpendicular to the observation plane.

Similarly, image 525, between image 521 and image 524, is judged to correspond to a weak radiation source, radiating to the left, which is comparatively near the observation plane.

With the above-described display apparatus, complex two-dimensional wave interference data can be displayed in a manner giving a feeling of distance in a direction at a right angle to the observation plane by converting the phase information into a hue signal and modulating the hue signal by amplitude information. That is, complex three-dimensional space can be displayed using two-dimensional computer graphics.

It is to be understood that the transfer function data, waveform data, etc. calculated by apparatus according to the invention can be outputted in some manner other than image display discussed above. Thus, for example, the data can be output to a printer for printing in any desired form including, but not limited to, an image representation, numerical data, a graph or chart, etc.; to a memory device; to a further data processing device; etc.

## Claims

1. A non-contact type transfer function measurement apparatus which inputs a signal to an input terminal (116) of a distributed constant network (111) under observation, comprising:
scanning-antenna receiving means (132) for receiving electromagnetic waves radiated from said network (111) at a number of observation points on an electromagnetic wave observation plane (131) set up for said network;
transfer function measuring means (100) for measuring transfer functions between said input terminal (116) of said network and said observation points;
transfer function reconstructing means (135) for reconstructing transfer functions between said input terminal and arbitrary reconstructed output points of said network by converting said measured transfer functions at each observation frequency using the inverse-Fresnel transform or the Fourier transform; and
display means (139) for displaying said reconstructed transfer functions of specified reconstructed output points of said network as frequency responses.

2. A non-contact type transfer function measurement apparatus according to claim 1 wherein said display means (143) displays a physical shape of said network, said reconstructed transfer function of arbitrary observation frequency in two dimensions, and frequency characteristic of the location as frequency response if an arbitrary position of said reconstructed function is specified.

3. A non-contact type transfer function measurement apparatus according to claim 2 wherein said display means displays said physical shape and said reconstructed transfer function in overlay fashion.

4. A non-contact type transfer function measurement apparatus according to claims 1 to 3 which further comprises characteristic compensating means (138) which compensates frequency characteristic of said transfer function measuring means (100).

5. A non-contact type transfer function Measurement apparatus according to claims 1 to 4 which further comprises domain converting means (141) which converts frequency responses to time-domain responses using the inverse-Fourier transform, and wherein said display means (142) displays said time-domain responses.

6. A non-contact type transfer function measurement apparatus according to claims 1 to 5 wherein said scanning-antenna receiving means is composed of an array antenna on said observation plane (131), and received signals of said array antenna are scanned then output.

7. A non-contact type transfer function measurement apparatus according to claims 1 to 5 wherein said scanning-antenna receiving means is composed of a scanning antenna (132) which is scanned to specified positions on said observation plane (131), and received signals of said scanning antenna are output at specified positions.

## Patentansprüche

1. Kontaktlose Übertragungsfunktions-Meßvorrichtung, die ein Signal in einen Eingangsanschluß (116) eines beobachteten konstanten Verteilnetzes (111) eingibt, wobei die Vorrichtung aufweist:
eine Abtastantennen-Empfangseinrichtung (132), die von dem Netzwerk (111) ausgestrahlte elektromagnetische Wellen bei einer Vielzahl von Beobachtungspunkten auf einer für dieses Netzwerk bestimmten Beobachtungsebene für elektromagnetische Wellen (131) empfängt;
eine Übertragungsfunktions-Meßeinrichtung (100), die Übertragungsfunktionen zwischen dem Eingangsanschluß (116) des Netzwerkes und den Beobachtungspunkten mißt;
eine Einrichtung zur Rekonstruktion der Übertragungsfunktion (135), die Übertragungsfunktionen zwischen dem Eingangsanschluß und beliebigen, rekonstruierten Ausgangspunkten des Netzwerkes rekonstruiert, indem die gemessene Übertragungsfunktion bei jeder Beobachtungsfrequenz unter der Verwendung der inversen Fresnel-Transformation oder der Fourier-Transformation umgewandelt wird; und
eine Anzeigeeinrichtung (139), die die rekonstruierten Übertragungsfunktionen von speziellen rekonstruierten Ausgabepunkten des Netzwerkes als Frequenzantworten darstellt.

2. Meßvorrichtung nach Anspruch 1, wobei die Anzeigeeinrichtung (143) eine physische Form des Netzwerks, die rekonstruierte Übertragungsfunktionen bei beliebiger Beobachtungsfrequenz in zwei Dimensionen und die Frequenzkennlinie des Ortes als Frequenzantwort anzeigt, wenn eine beliebige Position der rekonstruierten Funktion ausgewählt ist.

3. Meßvorrichtung nach Anspruch 2, wobei die Anzeigeeinrichtung die physische Form und die rekonstruierte Übertragungsfunktion übereinanderliegend darstellt.

4. Meßvorrichtung nach einem der Ansprüche 1 bis 3, die weiterhin eine Kennlinien-Kompensationseinrichtung (138) aufweist, die die Frequenzkennlinie der Übertragungsfunktions-Meßeinrichtung (100) kompensiert.

5. Meßeinrichtung nach einem der Ansprüche 1 bis 4, die weiterhin eine Bereichsumwandlungseinrichtung (141) aufweist, die unter Verwendung der inversen Fourier-Transformation die Frequenzantworten in Antworten im Zeitbereich umwandelt, wobei die Anzeigeeinrichtung (142) die Antworten im Zeitbereich darstellt.

6. Meßvorrichtung nach einem der Ansprüche 1 bis 5, wobei die Abtastantennen-Empfangseinrichtung aus einer Array-Antenne in der Beobachtungsebene (131) besteht und wobei die empfangenen Signale der Array-Antenne abgetastet und ausgegeben werden.

7. Meßvorrichtung nach einem der Ansprüche 1 bis 5, wobei die Abtastantennen-Empfangseinrichtung aus einer Abtastantenne (132) besteht, die auf bestimmte Positionen der Beobachtungsebene (131) abgetastet wird und wobei die empfangenen Signale der Abtastantenne bei bestimmten Positionen ausgegeben werden.

## Revendications

1. Dispositif de mesure de fonctions de transfert du type sans contact qui fournit en entrée un signal à une borne d'entrée (116) d'un réseau à constantes réparties (111) sous observation, comprenant :
un moyen de réception à antenne à balayage (132) destiné à recevoir des ondes électromagnétiques rayonnées à partir dudit réseau (111) à un certain nombre de points d'observation sur un plan d'observation d'ondes électromagnétiques (131) établi pour ledit réseau,
un moyen de mesure de fonctions de transfert (100) destiné à mesurer des fonctions de transfert entre ladite borne d'entrée (116) dudit réseau et lesdits points d'observation,
un moyen de reconstitution de fonctions de transfert (135) destiné à reconstituer des fonctions de transfert entre ladite borne d'entrée et des points de sortie reconstitués arbitraires dudit réseau en convertissant lesdites fonctions de transfert mesurées à chaque fréquence d'observation en utilisant la transformation de Fresnel inverse ou la transformation de Fourier, et
un moyen d'affichage (139) destiné à afficher lesdites fonctions de transfert reconstituées de points de sortie reconstitués spécifiés dudit réseau sous forme de réponses en fréquence.

2. Dispositif de mesure de fonctions de transfert du type sans contact selon la revendication 1, dans lequel ledit moyen d'affichage (143) affiche une forme physique dudit réseau, ladite fonction de transfert reconstituée à fréquence d'observation arbitraire en deux dimensions, et une caractéristique en fréquence de l'emplacement sous forme d'une réponse en fréquence si une position arbitraire de ladite fonction reconstituée est spécifiée.

3. Dispositif de mesure de fonctions de transfert du type sans contact selon la revendication 2, dans lequel ledit moyen d'affichage affiche ladite forme physique et ladite fonction de transfert reconstituée d'une façon en recouvrement.

4. Dispositif de mesure de fonctions de transfert du type sans contact selon les revendications 1 à 3 qui comprend en outre un moyen de compensation de caractéristique (138) qui compense une caractéristique en fréquence dudit moyen de mesure de fonctions de transfert (100).

5. Dispositif de mesure de fonctions de transfert du type sans contact selon les revendications 1 à 4 qui comprend en outre un moyen de conversion de domaine (141) qui convertit des réponses en fréquence en réponses du domaine temporel en utilisant la transformation de Fourier inverse, et dans lequel ledit moyen d'affichage (142) affiche lesdites réponses du domaine temporel.

6. Dispositif de mesure de fonctions de transfert du type sans contact selon les revendications 1 à 5, dans lequel ledit moyen de réception à antenne à balayage est composé d'une antenne-réseau sur ledit plan d'observation (131), et des signaux reçus de ladite antenne-réseau sont alors balayés en sortie.

7. Dispositif de mesure de fonctions de transfert du type sans contact selon les revendications 1 à 5, dans lequel ledit moyen de réception à antenne à balayage est composé d'une antenne à balayage (132) qui est balayée à des positions spécifiées sur ledit plan d'observation (131), et des signaux reçus de ladite antenne à balayage sont fournis en sortie à des positions spécifiées.
